# DEMANDE DE BREVET EUROPEEN

(11) **EP 0 843 511 A1**
(43) Date de publication de la demande: **20.05.1998**
(21) Numéro de dépôt: 97402579.3
(22) Date de dépôt: 30.10.1997
(51) Int. Cl.: H05K 7/14

(54) **Procédé de réhabilitation d'une armoire pour tiroirs pour cartes électroniques et armoire ainsi réhabilitée**

(30) Priorité: 04.11.1996 FR 9613396
(71) Demandeur: GEC ALSTHOM TRANSPORT SA, 75116 Paris (FR)
(72) Inventeur: Ruque, Christian, 69690 Corbas (FR)
(74) Mandataire: Gosse, Michel

(57) **Abrégé**

La présente invention porte sur un procédé de réhabilitation d'une armoire (100A) pour tiroirs (7) pour cartes électroniques, caractérisé en ce qu'il comporte les étapes consistant à:
- créer un tiroir électronique débrochable (13) ayant une connectique de raccordement (14) sur sa face arrière,
- adapter sur l'armoire à réhabiliter (100A) un support mécanique intermédiaire (9) supportant un ensemble de connecteurs flottants (10) de fond de tiroir électronique débrochable (13),
- créer une zone libre Z entre lesdits supports arrières (3) des connecteurs (4) de fond d'armoire (100A) et lesdits supports intermédiaires (9),
- adapter entre lesdits supports arrière (3) et lesdits supports intermédiaires (9) un câblage (11).

## Description

La présente invention concerne les armoires pour tiroirs pour cartes électroniques, en générale, et porte, plus particulièrement, sur un procédé de réhabilitation de ces armoires, ainsi que sur une armoire pour tiroirs pour cartes électroniques ainsi réhabilitée.

Le procédé de réhabilitation d'une armoire pour tiroirs pour cartes électroniques de l'invention est plus particulièrement décrit dans le cadre d'une application dans le domaine des transports ferroviaires.

L'armoire pour tiroirs pour cartes électroniques réhabilitée selon le procédé de réhabilitation de l'invention est de ce fait plus particulièrement destinée à être embarquée dans un véhicule ferroviaire.

Du fait de l'évolution rapide des composants électroniques et du fait que l'achat de matériel complet neuf représente un investissement lourd, de plus en plus d'exploitants de matériel sont amenés à réhabiliter le matériel existant.

Ceci est d'autant plus vrai que, généralement, la mécanique et l'électronique de puissance vieillissent bien et représentent la part importante du coût du matériel global.

A l'opposé, l'électronique de commande est bien souvent obsolète au bout de quelques années.

Les conséquences de ce qui précède sont que l'on ne trouve plus les composants sur le marché ou à des prix prohibitifs pour la réparation et que les coûts de maintenance sont élevés, au regard des nouvelles solutions possibles.

Au delà d'un certain coût, une réhabilitation de l'électronique de commande est envisagée.

Plusieurs solutions de l'art antérieur pour effectuer cette réhabilitation sont décrites ci-après.

Les armoires pour tiroirs pour cartes électroniques et les matériels à réhabiliter de l'art antérieur sont issus de normes anciennes, telles que la norme DIN 297, la norme CF 61002 et la norme XNF 61005.

De nouvelles normes doivent être respectées, telles que la norme EN 50 155 ou la norme CLC/TCYX (sec) 95 annexe de la EN 50 155.

Une première solution de l'art antérieur consiste à refaire les tiroirs de l'art antérieur à l'identique afin de retrouver des interfaces identiques au niveau de l'armoire.

Un inconvénient majeur de cette première solution de l'art antérieur est que le tiroir ne serait pas adapté aux nouvelles techniques et aux nouvelles normes, notamment en ce qui concerne les réduction de volume, la technique BUS et les nouvelles solutions de connectique.

Une seconde solution de l'art antérieur consiste à refaire de nouvelles armoires en intégrant des tiroirs possédant les technologies les plus récentes en tenant compte des nouvelles normes.

Un inconvénient majeur de cette seconde solution de l'art antérieur est qu'elle implique des coûts importants au niveau de l'étude d'intégration de l'armoire, du fait qu'il est nécessaire de refaire des armoires adaptées et du fait qu'il faut revoir l'ensemble du câblage, par exemple du véhicule dans le cas d'une application dans le domaine des transports, en adaptant l'ancien câblage au moyen de points de connections intermédiaires supplémentaires.

Un autre inconvénient de cette seconde solution de l'art antérieur est qu'elle implique des délais importants pour effectuer la réhabilitation, notamment pour l'étude d'adaptation et pour la réalisation car il faut démonter les anciennes armoires, modifier le câblage in situe et monter la nouvelle armoire.

Un autre inconvénient de cette seconde solution de l'art antérieur est qu'elle induit des risques de mauvais fonctionnement : cette seconde solution impose de retoucher un câblage déjà ancien, en rajoutant des câblages intermédiaires.

Un autre inconvénient de cette seconde solution de l'art antérieur est que la réhabilitation une fois effectuée est irréversible.

Le matériel de l'art antérieur à réhabiliter embarqué dans un véhicule, notamment ferroviaire, se présente dans une armoire implantée dans laquelle sont montés des tiroirs électroniques disposés les uns au dessus des autres.

Sur l'arrière, un fond d'armoire réalise le support des connecteurs flottant assurant avec un câblage approprié la réalisation des liaisons fonctionnelles entre les tiroirs et le câblage du véhicule. Des tiroirs sont enfichés par l'avant de l'armoire.

Sur l'arrière du tiroir, des connecteurs viennent s'enficher sur les connecteurs d'armoire.

Aussi un but de l'invention est-il un procédé de réhabilitation d'une armoire pour tiroirs pour cartes électroniques permettant d'obtenir une armoire ne présentant pas les inconvénients des armoires réhabilitées de l'art antérieur.

Conformément à l'invention, le procédé de réhabilitation d'une armoire pour tiroirs pour cartes électroniques se caractérise en ce qu'il comporte les étapes consistant à:
- créer un tiroir électronique débrochable ayant une connectique de raccordement sur sa face arrière et dont la profondeur P est inférieure à la profondeur L du tiroir à réhabiliter,
- adapter sur l'armoire à réhabiliter un support mécanique intermédiaire supportant un ensemble de connecteurs flottants de fond de tiroir électronique débrochable,
- conserver de ladite armoire à réhabiliter, un ensemble mécanique d'armoire, des supports arrières de connecteurs de fond des tiroirs à réhabiliter, l'ensemble desdits connecteurs de fond desdits tiroirs à réhabiliter et le câblage de sortie de l'armoire,
- créer une zone libre Z entre lesdits supports arrières des connecteurs de fond d'armoire et lesdits supports intermédiaires équipés desdits connecteurs flottants de fond de tiroir électronique débrochable,
- adapter entre lesdits supports arrière et lesdits supports intermédiaires un câblage et/ou des tiroirs de fond reliant lesdits connecteurs flottants de fond de tiroir électronique débrochable et lesdits connecteurs de fond d'armoire.

Le procédé de réhabilitation d'une armoire pour tiroirs pour cartes électroniques de l'invention satisfait également à l'une quelconque des caractéristiques suivantes:
- ledit câblage est relié auxdits connecteurs de fond d'armoire au moyen de connecteurs de liaison,
- lesdits supports intermédiaires sont réalisés de manière à être introduit et à se fixer par l'avant de l'armoire à réhabiliter.

Conformément à une autre caractéristique de l'invention, l'armoire pour tiroirs pour cartes électroniques comprend un ensemble mécanique d'armoire comprenant des supports arrière de connecteurs de fond des tiroirs à réhabiliter, un ensemble de connecteurs de fond des tiroirs à réhabiliter et un câblage de sortie de l'armoire et ladite armoire se caractérise en ce que:
- ladite armoire est susceptible de recevoir au moins un tiroir électronique débrochable ayant une connectique de raccordement sur sa face arrière et dont la profondeur P est inférieure à la profondeur L dudit tiroir à réhabiliter,
- un support mécanique intermédiaire supporte un ensemble de connecteurs flottants de raccordement de fond de tiroir électronique débrochable,
- une zone libre Z entre lesdits supports arrière des connecteurs de fond d'armoire et lesdits supports intermédiaires équipés de connecteurs de fond de tiroir électronique débrochable,
- un câblage et/ou des tiroirs de fond entre lesdits supports arrière et lesdits supports intermédiaires.

L'armoire pour tiroirs pour cartes électroniques de l'invention satisfait également à l'une quelconque des caractéristiques suivantes:
- ledit câblage est relié auxdits connecteurs de fond d'armoire au moyen de connecteurs de liaison,
- ladite armoire a été réhabilitée conformément au procédé de réhabilitation de l'invention.

Un avantage du procédé de réhabilitation d'une armoire pour tiroirs pour cartes électroniques de l'invention est de ne pas retoucher à la structure de l'armoire existante.

Un autre avantage du procédé de réhabilitation d'une armoire pour tiroirs pour cartes électroniques de l'invention est de ne pas toucher au câblage du véhicule.

Un autre avantage du procédé de réhabilitation d'une armoire pour tiroirs pour cartes électroniques de l'invention est de diminuer les coûts globaux de la réhabilitation au niveau de l'étude et de la réalisation.

Un autre avantage du procédé de réhabilitation d'une armoire pour tiroirs pour cartes électroniques de l'invention est de limiter le temps d'immobilisation du véhicule.

Un autre avantage du procédé de réhabilitation d'une armoire pour tiroirs pour cartes électroniques de l'invention est de rendre réversible la réhabilitation si cela s'avérerai nécessaire.

Un autre avantage du procédé de réhabilitation d'une armoire pour tiroirs pour cartes électroniques de l'invention est de diminuer les risques techniques.

D'autres buts, caractéristiques et avantages de l'invention apparaîtront à la lecture de la description du procédé préféré de réhabilitation d'une armoire pour tiroirs pour cartes électroniques, ainsi que de l'armoire ainsi réhabilitée, description faite en liaison avec les dessins dans lesquels:
- La figure 1 est une vue en perspective avant d'une armoire avant réhabilitation comportant un tiroir pour cartes électroniques selon l'art antérieur.
- La figure 2 est une vue en perspective de dessus d'une armoire après réhabilitation comportant un tiroir pour cartes électroniques selon l'invention.

Le procédé de réhabilitation d'une armoire pour tiroirs pour cartes électroniques de l'invention comporte les étapes consistant en ce que:
- on crée un tiroir électronique débrochable 13 ayant une connectique de raccordement 14 sur sa face arrière et dont la profondeur P est inférieure à la profondeur L du tiroir à réhabiliter 7,
- on adapte sur l'armoire à réhabiliter 100A un support mécanique intermédiaire 9 supportant l'ensemble des connecteurs flottants 10 dudit tiroir électronique débrochable 13,
- on conserve de ladite armoire à réhabiliter 100A, un ensemble mécanique d'armoire obtenu, par exemple, par l'assemblage de poteaux 1 avec des flasques latéraux 2 et des supports arrière 3 des connecteurs 4 de fond des tiroirs à réhabiliter, l'ensemble desdits connecteurs 4 de fond des tiroirs à réhabiliter et le câblage de sortie 5 de l'armoire 100A,
- on crée une zone libre Z entre lesdits supports arrière 3 des connecteurs 4 de fond d'armoire 100A et lesdits supports intermédiaires 9 équipés de connecteurs 10 de fond de tiroir électronique débrochable 13,
- on adapte entre lesdits supports arrière 3 et lesdits supports intermédiaires 9 un câblage 11 ou un tiroir intermédiaire (non représenté).

De préférence, le nouveau support arrière est réalisé de façon à passer et à se fixer de façon simple par l'avant de l'armoire à réhabiliter.

Il est préférable de préparer l'ensemble du tiroir intermédiaire à l'extérieur du véhicule de manière à ce que dans le véhicule seuls restent à brancher les connecteurs arrière et à fixer le ou les nouveaux supports intermédiaires équipés des connecteurs câblés.

Le procédé de réhabilitation d'une armoire pour tiroirs pour cartes électroniques selon l'invention permet de réaliser un ou des nouveaux tiroirs optimum en terme, notamment, de regroupement fonctionnel, de hauteur, de largeur, de sortie de câble et de type de connectique.

Le procédé de réhabilitation d'une armoire pour tiroirs pour cartes électroniques selon l'invention permet de réduire de façon considérable le coût des études.

En effet, seul le tiroir intermédiaire avec le support intermédiaire est à étudier, si on considère que le nouveau tiroir est développé par ailleurs.

Le procédé de réhabilitation d'une armoire pour tiroirs pour cartes électroniques selon l'invention permet de réduire de façon considérable le coût de la réhabilitation au niveau produit.

En effet, l'armoire et le câblage de sortie d'armoire sont conservés.

De plus, les nouveaux tiroirs utilisés sont standardisés et adaptés aux nouvelles normes, donc optimisés.

Enfin, la réalisation du tiroir intermédiaire peut être fait à l'extérieur du véhicule.

Le procédé de réhabilitation d'une armoire pour tiroirs pour cartes électroniques selon l'invention permet de réduire de façon considérable le temps d'intervention sur le véhicule et donc de réduire la durée d'immobilisation du véhicule.

Le procédé de réhabilitation d'une armoire pour tiroirs pour cartes électroniques selon l'invention permet de réduire de façon considérable les risques de panne inhérent à la retouche du câblage ancien.

Le procédé de réhabilitation d'une armoire pour tiroirs pour cartes électroniques selon l'invention est réversible, on peut donc facilement revenir à la situation avant réhabilitation.

Cet avantage est important quant on connaît les risques inhérent à la retouche du câblage existant.

En effet, une retouche du câblage existant nécessite de couper des câbles anciens dont l'isolant est fragilisé.

De plus, dans le cas de câbles blindés, l'apparition de connecteurs impose une interruption du blindage et modifie donc de façon défavorable les caractéristiques électriques initiales.

D'autre part, la réhabilitation se fait en général sur de longues périodes, le procédé de réhabilitation selon l'invention permet de gérer facilement la réhabilitation en réduisant le nombre des dossiers de câblage entre l'état réhabilité et non réhabilité.

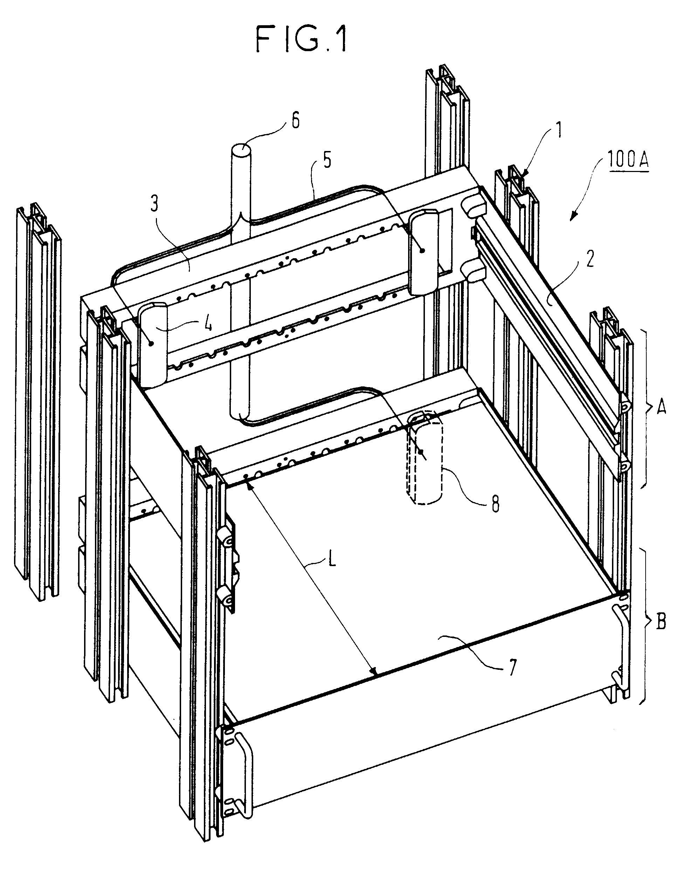

La figure 1 est une vue en perspective avant d'une armoire avant réhabilitation 100A comportant un tiroir 7 pour cartes électroniques selon l'art antérieur.

Sur cette figure 1 est représenté un ensemble mécanique d'armoire obtenu par l'assemblage de poteaux 1 avec des flasques latéraux 2 et des supports arrières 3 de connecteurs 4 de fond de tiroir.

Les connecteurs 4 de fond de tiroir sont montés flottant et reprennent le câblage d'armoire 5.

Le câblage d'armoire 5 est réalisé par des liaisons diverses aboutissant soit sur les connecteurs 4 de fond de tiroir, soit sur des connecteurs 6 d'armoire.

Ce câblage d'armoire 5 est situé à l'arrière des supports connecteurs 3.

Pour mieux comprendre la description relative à l'armoire avant réhabilitation, la figure 1 montre, dans une même armoire, deux états du tiroir.

Dans la zone A, l'armoire est représentée sans le montage du tiroir à réhabiliter 7 pour cartes électroniques.

Dans la zone B, le tiroir à réhabiliter 7 pour cartes électroniques est représenté dans l'armoire en position introduite.

Ce tiroir à réhabiliter 7 pour cartes électroniques de forme parallélépipédique possède un connecteur tiroir 8 qui vient s'enficher dans le connecteur 4 de fond de tiroir et réalise la liaison fonctionnelle nécessaire au bon fonctionnement.

Ce tiroir 7 possède les caractéristiques de profondeur L telles qu'il utilise toute la place disponible à l'avant du support connecteurs 3.

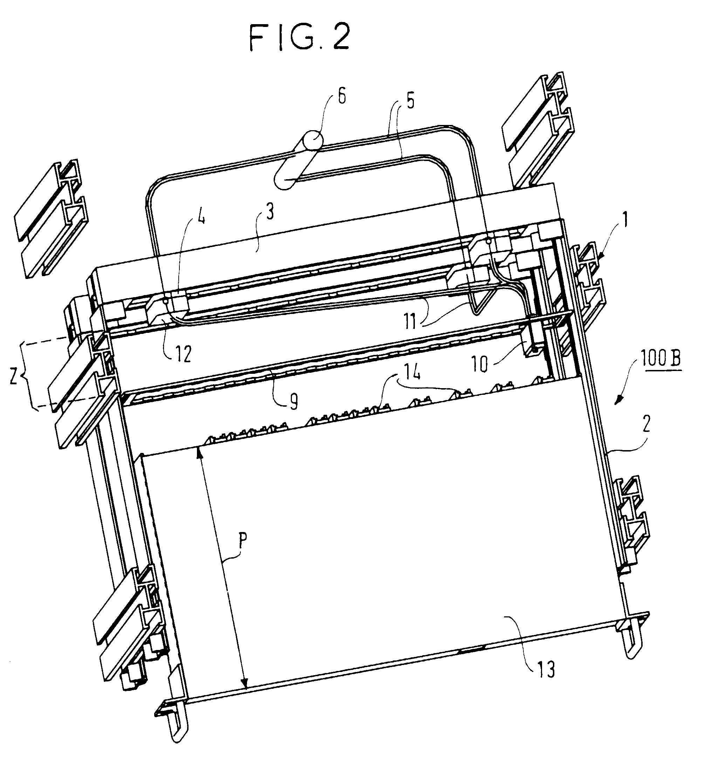

La figure 2 est une vue en perspective de dessus d'une armoire 100B après réhabilitation comportant un tiroir pour cartes électroniques selon l'invention.

Sur cette figure 2 est représenté le même ensemble mécanique d'armoire que celui représenté en figure 1.

A titre d'exemple, l'ensemble mécanique d'armoire est donc également obtenu par l'assemblage de poteaux 1 avec des flasques latéraux 2 et des supports arrière 3 de connecteurs 4 de fond de tiroir.

Les connecteurs de fond de tiroir 4 reprennent également le câblage d'armoire 5.

A l'armoire à réhabiliter 100A, représentée en figure 1, a été retiré le tiroir ancien 7 et a été disposé à l'avant des supports arrières 3 de connecteur un support intermédiaire 9 de connecteurs qui supporte des connecteurs flottants 10 de fond de tiroir.

De ces connecteurs flottants 10 partent des liaisons de câblage 11 qui sont reliées à l'autre extrémité à des connecteurs de liaisons 12.

Ces connecteurs de liaison 12 sont fixés et reliés aux connecteurs 4 de fond de tiroir de manière à assurer la continuité fonctionnelle des liaisons entre le connecteur d'armoire 6 et le tiroir électronique débrochable 13 équipé des connecteurs arrières 14 adaptés.

Le tiroir électronique débrochable 13 permettant la mise en oeuvre du procédé de réhabilitation de l'invention possède une profondeur P réduite de telle sorte qu'il s'adapte une fois enfiché en lieu et place de l'ancien tiroir 7.

Le tiroir électronique débrochable 13 étant complètement enfiché, la face avant du tiroir se juxtapose avec la face du flasque latéral 2.

Dans une telle position du tiroir, les connecteurs 10 et 14 sont reliés électriquement.

## Revendications

1. Procédé de réhabilitation d'une armoire (100A) pour tiroirs (7) pour cartes électroniques, caractérisé en ce qu'il comporte les étapes consistant à:
- créer un tiroir électronique débrochable (13) ayant une connectique de raccordement (14) sur sa face arrière et dont la profondeur P est inférieure à la profondeur L du tiroir à réhabiliter (7),
- adapter sur l'armoire à réhabiliter (100A) un support mécanique intermédiaire (9) supportant un ensemble des connecteurs flottants (10) de fond de tiroir électronique débrochable (13),
- conserver de ladite armoire à réhabiliter (100A), un ensemble mécanique d'armoire (1, 2), des supports arrière (3) des connecteurs (4) de fond des tiroirs à réhabiliter, l'ensemble desdits connecteurs (4) de fond desdits tiroirs à réhabiliter (7) et le câblage de sortie (5) de l'armoire (100A),
- créer une zone libre Z entre lesdits supports arrières (3) des connecteurs (4) de fond d'armoire (100A) et lesdits supports intermédiaires (9) équipés desdits connecteurs flottants (10) de fond de tiroir électronique débrochable (13),
- adapter entre lesdits supports arrière (3) et lesdits supports intermédiaires (9) un câblage (11) et/ou des tiroirs de fond reliant lesdits connecteurs flottants (10) de fond de tiroir électronique débrochable (13) et lesdits connecteurs (4) de fond d'armoire (100A).

2. Procédé selon la revendication 1, dans lequel ledit câblage (11) est relié auxdits connecteurs (4) de fond d'armoire (100A) au moyen de connecteurs de liaison (12).

3. Procédé selon la revendication 1, dans lequel lesdits supports intermédiaires (9) sont réalisés de manière à être introduit et à se fixer par l'avant de l'armoire à réhabiliter (100A).

4. Armoire (100B) pour tiroir pour cartes électroniques, ladite armoire comprenant un ensemble mécanique d'armoire comprenant des supports arrières (3) de connecteurs (4) de fond des tiroirs à réhabiliter (7), un ensemble de connecteurs (4) de fond des tiroirs à réhabiliter et un câblage de sortie (5) de l'armoire (100A), ladite armoire étant caractérisé en ce que:
- ladite armoire est susceptible de recevoir au moins un tiroir électronique débrochable (13) ayant une connectique de raccordement (14) sur sa face arrière et dont la profondeur P est inférieure à la profondeur L dudit tiroir à réhabiliter (7),
- un support mécanique intermédiaire (9) supporte un ensemble de connecteurs flottants de raccordement (10) de fond de tiroir électronique débrochable (13),
- une zone libre Z entre lesdits supports arrière (3) des connecteurs (4) de fond d'armoire (100A) et lesdits supports intermédiaires (9) équipés desdits connecteurs flottants (10) de fond de tiroir électronique débrochable (13),
- un câblage (11) et/ou des tiroirs de fond entre lesdits supports arrière (3) et lesdits supports intermédiaires (9).

5. Armoire selon la revendication 4, dans laquelle ledit câblage (11) est relié auxdits connecteurs (4) de fond d'armoire (100A) au moyen de connecteurs de liaison (12).

6. Armoire selon l'une quelconque des revendications 4 et 5, laquelle a été réhabilitée conformément au procédé de réhabilitation selon l'une quelconque des revendications 1 à 3.
